# EUROPÄISCHE PATENTSCHRIFT

(11) **EP 2 438 802 B1**
(45) Veröffentlichungstag und Bekanntmachung des Hinweises auf die Patenterteilung: **25.12.2013**
(21) Anmeldenummer: 10724726.4
(22) Anmeldetag: 17.05.2010
(51) Int. Cl.: H05K 1/14, H05K 3/36, H01R 13/24

(54) **PRINTPLATTENANORDNUNG**
ARRANGEMENT OF PRINTED CIRCUIT BOARDS
DISPOSITION DES PLATINES À PISTE IMPRIMÉES

(30) Priorität: 02.06.2009 CH 838092009
(43) Veröffentlichungstag der Anmeldung: 11.04.2012
(73) Patentinhaber: Huber+Suhner AG, 9100 Herisau (CH)
(72) Erfinder: WAGNER, Martin, 9323 Steinach (CH); FUCHS, Josef, CH-9050 Appenzell (CH)
(74) Vertreter: Rentsch Partner AG
(86) Internationale Anmeldenummer: PCT/EP2010/056733
(87) Internationale Veröffentlichungsnummer: WO 2010/139549

(56) Entgegenhaltungen:
- US-A1- 2001 012 723

## Beschreibung

Die vorliegende Erfindung bezieht sich auf das Gebiet der elektronischen Schaltungstechnik auf dem Höchstfrequenzgebiet im Bereich von bis zu mehreren GHz Betriebsfrequenz. Sie betrifft eine Printplattenanordnung gemäss dem Oberbegriff des Anspruchs 1.

In der modernen Kommunikationstechnik und auf anderen mit Höchstfrequenz arbeitenden Gebieten werden elektronische Schaltungen auf gedruckten Schaltungsplatten oder Printplatten (PCBs oder Printed Circuit Boards) aufgebaut, die auf einer elektrisch isolierenden Trägerplatte eine oder mehrere Leiterschichten aufweisen, die zumindest teilweise strukturiert sind und Leiterbahnen oder -flächen bilden, die auf der Trägerplatte aufgebrachte bzw. aufgelötete elektronische Bauelemente untereinander bzw. mit der Aussenwelt verbinden.

Bei grösseren Geräteeinheiten wie z.B. Basisstationen für die Mobilfunktechnik sind mehrere separate Printplatten in einem Gerät untergebracht und müssen nach oder bei dem Einbau in das Gerät untereinander elektrisch verbunden werden. Viele der erforderlichen Verbindungen müssen dabei HF-tauglich sein, um Signale bei den hohen Betriebsfrequenzen im GHz-Bereich sicher von einer Printplatte zur anderen weiterleiten zu können. Grundsätzlich können derartige nachträgliche Verbindungen gelötet werden, was jedoch mit einem erheblichen Arbeitsaufwand verbunden ist, insbesondere, wenn eine Vielzahl derartiger Verbindungen hergestellt werden müssen. Auch ist es möglich, die Verbindungen durch kurze Leitungen mit Steckverbindern herzustellen, was jedoch gleichfalls mit einem erheblichen Arbeitsaufwand verbunden ist und zusätzlich einen nicht unwesentlichen Platz beansprucht.

Sind die zu verbindenden Printplatten übereinander oder zumindest teilweise überlappend angeordnet, können druckkontaktierte, vorzugsweise koaxiale HF-Verbindungen eingesetzt werden, wie sie beispielsweise aus den Druckschriften US-B1-6,231,352 oder US-B2-7,416,418 oder US-B2-7,210,941 oder EP-A2-1 289 076 oder WO-A1-2007/009549 bekannt sind.

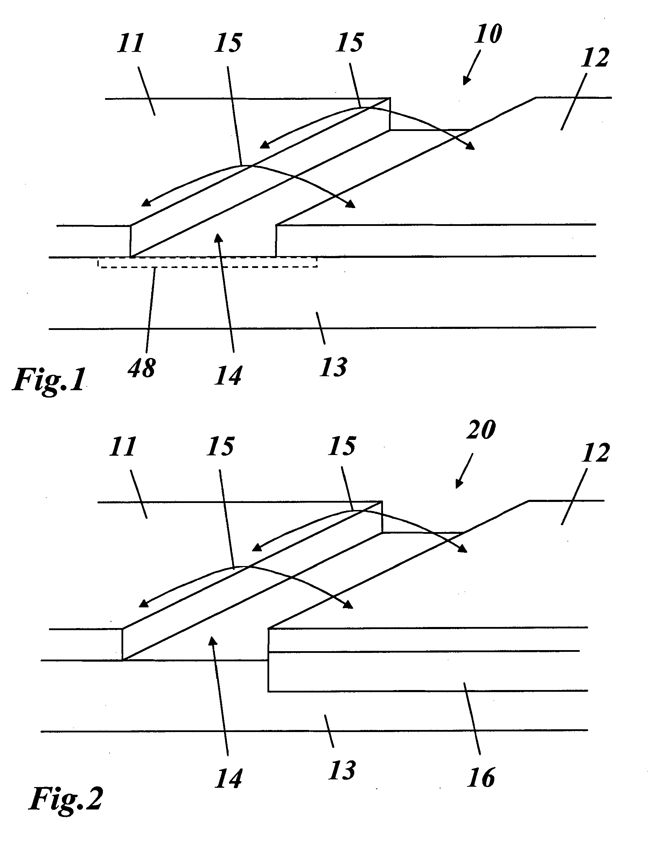

Eine andere Situation ergibt sich jedoch bei Printplattenanordnungen gemäss Fig. 1 oder Fig. 2. Bei der in Fig. 1 wiedergegebenen Printplattenanordnung 10 sind zwei Printplatten 11 1 und 12 nebeneinander auf einer gemeinsamen, dickeren Basisplatte 13 angeordnet, die insbesondere der Wärmeableitung dient und beispielsweise aus Aluminium bestehen kann. Die beiden Printplatten 11 und 12 sind mit zwei gegenüberliegenden Kanten mit Abstand parallel zueinander ausgerichtet und bilden so zwischen sich einen Zwischenraum 14, der durch HF-taugliche elektrische Verbindungen 15 überbrückt werden muss, die in Fig. 1 als Doppelpfeile schematisch eingezeichnet sind. Der Zwischenraum 14 ist nicht zwingend not wendig, sondern die Printplatten 11, 12 können mit den Kanten auch direkt aneinanderstossen.

Bei der in Fig. 2 gezeigten Printplattenanordnung 20 ist die Situation ähnlich mit dem Unterschied, dass eine der Printplatten, nämlich die Printplatte 12', speziell für eine Schaltung hoher Leistung ausgelegt ist und daher auf der Unterseite zusätzlich mit einer Ableitplatte 16 versehen ist, welche die in den Bauelementen entstehende Wärme unmittelbar aufnehmen und verteilen soll (sog. "heat spreader plate"), bevor sie dann an die Basisplatte 13' weitergeleitet wird. Die Ableitplatte 16 kann beispielsweise aus gesintertem Aluminium bestehen. Sie vergrössert die Dicke der Printplatte 12' gegenüber der Dicke der Printplatte 11. Zum Ausgleich ist in der Basisplatte 13' eine entsprechende Dickenstufe vorgesehen.

Für die elektrische Verbindung nebeneinander angeordneter Printplatten sind in der US-B1-6,612,851 bereits mit Druck arbeitende Verbindungsvorrichtungen vorgeschlagen worden, die allerdings auf die Ober- und Unterseite der Printplatten wirken und daher für auf einer Basisplatte angeordnet Printplatten nicht geeignet sind.

Weiterhin sind in der US-B1-6,464,510 Mikrowellen-Verbinder offenbart worden, die beide Printplatten auf der Oberseite mit Druckkontakten verbinden. Die Verbinder müssen jedoch nachträglich eingebaut und mit einer oder beiden Printplatte verschraubt werden, was umständlich und fehleranfällig ist.

Aus der US-A-3,591,834 ist schliesslich offenbart eine Art Steckverbindersystem, bei welchem die beiden Printplatten mit ihren gegenüberliegenden Seitenkanten in eine dafür vorgesehen Vorrichtung von der Seite kontaktierend eingeführt werden müssen. Auch diese Verbindungstechnik ist für auf einer Basisplatte aufliegende Printplatten nicht geeignet

Es ist daher Aufgabe der Erfindung, eine Printplattenanordnung der eingangs genannten Art zu schaffen, bei der auf einfache und platzsparende Weise bei der Montage der Printplatten auf der Basisplatte und ohne weitere notwendige Zusatz- oder Nacharbeiten HFtaugliche elektrische Verbindungen zwischen den Printplatten hergestellt werden, die als Signalleitungen bis in den Höchstfrequenzbereich von mehreren GHz geeignet sind.

Die Aufgabe wird durch die Gesamtheit der Merkmale des Anspruchs 1 gelöst. Wesentlich für die erfindungsgemässe Lösung ist, dass die elektrischen Verbindungen jeweils über wenigstens ein Kontaktierungselement erfolgen, über das die Printplatten bei der Montage auf der Basisplatte lösbar miteinander in elektrischen Kontakt treten.

Eine Ausgestaltung der erfindungsgemässen Vorrichtung ist dadurch gekennzeichnet, dass die elektrischen Verbindungen zwischen den beiden Printplatten durch Ausübung von gegenseitigem Druck zwischen den Printplatten und/oder durch Druck zwischen den Printplatten und der Basisplatte hergestellt und aufrecht erhalten werden. Der Kontakt wird in diesem Fall also nicht klemmend hergestellt, sondern durch einen von den Printplatten ausgeübten Druck.

Dabei kann der Druck senkrecht zur Ebene der Printplatten wirken. Dies ist der Fall, wenn die Printplatten auf ein darunter angeordnetes Kontaktelement drücken.

Der Druck kann aber auch parallel zu den gegenüberliegenden Kanten der Printplatten wirken. Dies ist dann der Fall, wenn die Printplatten Kontaktvorrichtungen aufweisen, die sich im Zwischenraum überlappen.

Gemäss einer weiteren Ausgestaltung der Erfindung ist zum Herstellen der elektrischen Verbindungen mindestens ein Kontaktierungselement vorgesehen, welches unterhalb der beiden Printplatten in einer Ausnehmung der Basisplatte angeordnet ist und beide Printplatten von unten lösbar kontaktiert und miteinander verbindet

Eine Weiterbildung dieser Ausgestaltung der Erfindung zeichnet sich dadurch aus, dass das Kontaktierungselement eine Kontaktwippe aufweist, die mit einem Mittelstück in einem isolierenden Tragkörper angeordnet und gehalten ist und an den Enden jeweils mit einer nach oben gebogenen Kontaktzunge aus dem Tragkörper nach oben heraussteht, und dass der Tragkörper mit der Kontaktwippe derart in der zugehörigen Ausnehmung der Basisplatte sitzt, dass die Kontaktzungen gleichzeitig von unten kontaktierend gegen die auf der Basisplatte aufliegenden Printplatten drücken.

Der Tragkörper kann aus den unterschiedlichsten Isoliermaterialien bestehen. Vorzugsweise besteht der Tragkörper jedoch aus einem Elastomer und wird in der Ausnehmung klemmend gehalten, wobei die Kontaktwippe in einer Vertiefung auf der Oberseite des Tragkörpers klemmend gehalten wird.

Dabei hat sich bewährt, dass die Ausnehmung die Form eines Langlochs aufweist, und die Randkontur des Tragkörpers der Randkontur der Ausnehmung angepasst ist.

Eine weitere Ausgestaltung der Erfindung ist dadurch gekennzeichnet, dass zur Kontaktierung durch die Kontaktzungen der Kontaktwippe auf der Unterseite der beiden Printplatten jeweils eine Kontaktfläche vorgesehen ist, die über eine Durchkontaktierung mit einer Leiterbahn auf der Oberseite der Printplatte verbunden ist

Gemäss einer anderen Ausgestaltung sind Mittel vorgesehen, um wenigstens eine der Printplatten im Bereich der Kontaktzungen gegen den Druck der Kontaktwippe auf der Basisplatte niederzuhalten.

Eine weitere Ausgestaltung der erfindungsgemässen Vorrichtung zeichnet sich dadurch aus, dass zwischen den beiden Printplatten ein Zwischenraum frei bleibt, dass die Kontaktwippe im Bereich des Zwischenraums unterhalb der Ebene der Oberseite der Basisplatte verläuft, und dass ein elektrisch leitendes Gehäuseteil mit einer vertikalen Trennwand im Bereich des Zwischenraums auf die Basisplatte derart kontaktierend aufsetzt, dass der Raum oberhalb der beiden Printplatten in zwei den Printplatten zugeordnete, separate, abgeschirmte Räume unterteilt wird.

Es ist aber auch denkbar, dass das Kontaktierungselement eine weitere Printplatte aufweist, auf der im Bereich der Printplatten Kontaktpfosten angeordnet und über die weitere Printplatte untereinander leitend verbunden sind, und dass die weitere Printplatte mit den Kontaktpfosten derart in der zugehörigen Ausnehmung der Basisplatte sitzt, dass die Kontaktpfosten gleichzeitig von unten kontaktierend gegen die auf der Basisplatte aufliegenden Printplatten drücken. Hierfür können Kontaktpfosten eingesetzt werden, wie sie beispielsweise aus der US-B1-6,231,352 bekannt sind.

Eine Ausgestaltung, die ohne Eingriff in die Basisplatte auskommt, ist dadurch gekennzeichnet, dass zwischen den beiden Printplatten ein Zwischenraum frei bleibt, dass zum Herstellen der elektrischen Verbindungen jeweils zwei Kontaktierungselemente vorgesehen sind, welche auf der Oberseite der beiden Printplatten derart angeordnet sind, dass sie von beiden Seiten in den Zwischenraum hineinragen und sich lösbar kontaktieren und die beiden Printplatten miteinander verbinden.

Vorzugsweise sind die beiden Kontaktierungselemente gleich, wobei jedes Kontaktierungselement als anlötbares Stanzbiegeteil ausgebildet ist und einen U-förmigen Körper aufweist, aus dem seitlich ein federnder Kontaktarm herausragt und an seinem freien Ende mit einem Kontaktabschnitt versehen ist, und wobei die beiden Kontaktierungselemente mit ihren Kontaktabschnitte im Zwischenraum überlappen und federnd gegeneinander drücken.

Insbesondere sind solche Kontaktierungselemente dadurch gekennzeichnet, dass sie jeweils am Körper angeformte Lötfüsse aufweisen, dass in den Kontaktabschnitten oben jeweils ein schräg nach aussen abgebogenes Einlaufelement angeformt ist, dass in den Kontaktabschnitten unten jeweils ein rechtwinklig nach aussen abgebogenes Leitungselement angeformt ist, und dass die Kontaktabschnitte von oben in den Zwischenraum eintauchen.

Eine andere Ausgestaltung der Printplattenanordnung nach der Erfindung ist dadurch gekennzeichnet, dass das Kontaktierungselement einen Kontaktkörper aufweist, der mit einem Grundkörper in einem isolierenden Tragkörper angeordnet und gehalten ist und an den Enden jeweils mit einer nach oben zurückgebogenen Kontaktzunge aus dem Tragkörper nach oben heraussteht, und dass der Tragkörper mit dem Kontaktkörper derart in der zugehörigen Ausnehmung der Basisplatte sitzt, dass die Kontaktzungen gleichzeitig von unten kontaktierend gegen die auf der Basisplatte aufliegenden Printplatten drücken.

Insbesondere besteht der Tragkörper aus einem Elastomer und wird in der Ausnehmung klemmend gehalten.

Vorzugsweise weist die Ausnehmung die Form eines Langlochs auf, und die Randkontur des Tragkörpers ist der Randkontur der Ausnehmung angepasst.

Mit Vorteil ist zur Kontaktierung durch die Kontaktzungen des Kontaktkörpers auf der Unterseite der beiden Printplatten jeweils eine Kontaktfläche vorgesehen, die über eine Durchkontaktierung mit einer Leiterbahn auf der Oberseite der Printplatte verbunden ist

Die Erfindung soll nachfolgend anhand von Ausführungsbeispielen im Zusammenhang mit der Zeichnung näher erläutert werden. Es zeigen
- Fig. 1: in einer Schemadarstellung die HF-mässige Verbindung zweier auf einer gemeinsamen Basisplatte aufliegenden Printplatten in einer ersten Konfiguration, wie sie der vorliegenden Erfindung zugrunde liegt;
- Fig. 2: in einer Schemadarstellung die HF-mässige Verbindung zweier auf einer gemeinsamen Basisplatte aufliegenden Printplatten in einer zweiten Konfiguration, wie sie der vorliegenden Erfindung zugrunde liegt;
- Fig. 3: in einer Schnittdarstellung eine Printplattenanordnung mit zwei über ein in die Basisplatte eingesetztes Kontaktierungselement HF-mässig verbundenen Printplatten gemäss einem ersten Ausführungsbeispiel der Erfindung;
- Fig. 4: eine perspektivische Darstellung des in die Basisplatte einsetzbaren Kontaktierungselements aus Fig. 3;
- Fig. 5: in einer Explosionsdarstellung das Kontaktierungselement aus Fig. 4 über der mit einer entsprechenden Ausnehmung versehenen Basisplatte;
- Fig. 6: in einer perspektivischen Ansicht von oben den elektrischen Verbindungsweg in der Anordnung gemäss Fig. 3, wobei das Trägermaterial der Printplatten der Sichtbarkeit wegen weggelassen ist;
- Fig. 7: eine Printplatte mit einem aufgelöteten Kontaktierungselement für eine Printplattenanordnung gemäss einem zweiten Ausführungsbeispiel der Erfindung;
- Fig. 8: in einer zu Fig. 3 vergleichbaren Schnittdarstellung eine Printplattenanordnung mit zwei über Kontaktierungselemente gemäss Fig. 7 HF-mässig verbundene Printplatten gemäss dem zweiten Ausführungsbeispiel der Erfindung;
- Fig. 9: die Printplattenanordnung gemäss Fig. 8 in einer perspektivischen Ansicht von oben;
- Fig. 10: ein zu Fig. 3 vergleichbares drittes Ausführungsbeispiel der Erfindung, bei der an sich bekannte Kontaktpfosten eingesetzt werden;
- Fig. 11: die Printplattenanordnung gemäss Fig. 3 als Teil einer abgeschirmten HF-Baugruppe
- Fig. 12: in mehreren Teilfiguren 12(a), 12(b) und 12(c) verschiedene Ansichten (perspektivische Seitenansicht, Draufsicht von oben, Längsschnitt) eines weiteren Ausführungsbeispiels der Erfindung;
- Fig. 13: in einer Explosionsdarstellung (13(a)) und einem vergrößerten Ausschnitt (13(b)) die Printplattenanordnung aus Fig. 12;
- Fig. 14: eine der Printplatten aus Fig. 12 in der perspektivischen Ansicht schräg von oben; und
- Fig. 15: die Printplatte aus Fig. 14 in der perspektivischen Ansicht schräg von unten.

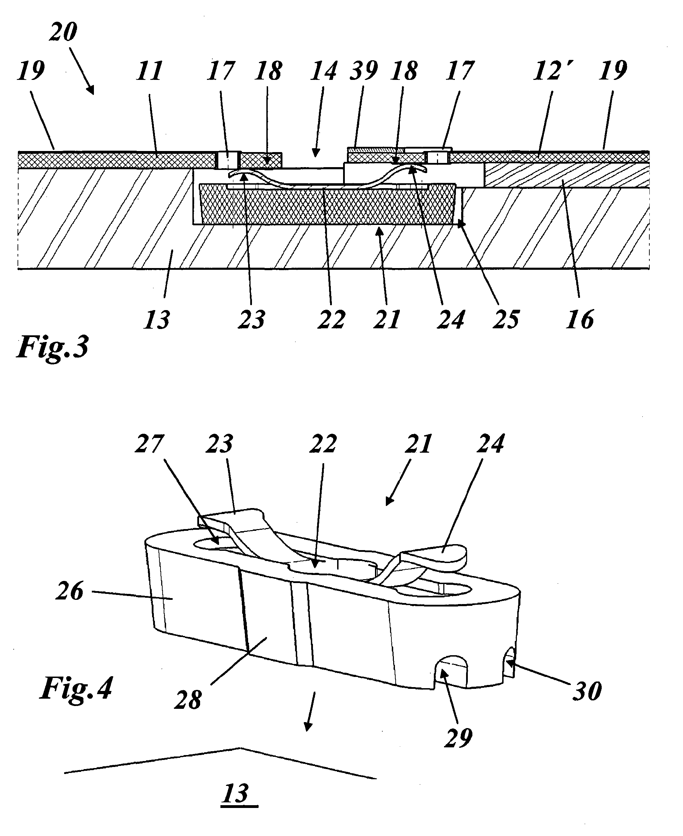

In Fig. 3 ist in einer Schnittdarstellung eine Printplattenanordnung mit zwei über ein in die Basisplatte eingesetztes Kontaktierungselement HF-mässig verbundenen Printplatten gemäss einem ersten Ausführungsbeispiel der Erfindung gezeigt. Die Printplattenanordnung 20, die eine in der Dicke abgestufte Basisplatte 13' nach dem in Fig. 2 dargestellten Prinzip aufweist, umfasst zwei unterschiedlich dicke Printplatten 11 und 12', wobei die dickere Printplatte 12' durch eine bereits eingangs erwähnte thermische Ableitplatte 16 auf der Unterseite für höhere thermische Belastungen ausgelegt ist. Die beiden Printplatten 11 und 12' liegen mit gegenseitigem Abstand auf der darunter angeordneten Basisplatte 13' auf, so dass ein Zwischenraum 14 frei bleibt, der für die elektrische Verbindung der beiden Printplatten 11, 12' pro Signalleitung durch ein Kontaktierungselement 21 überbrückt wird.

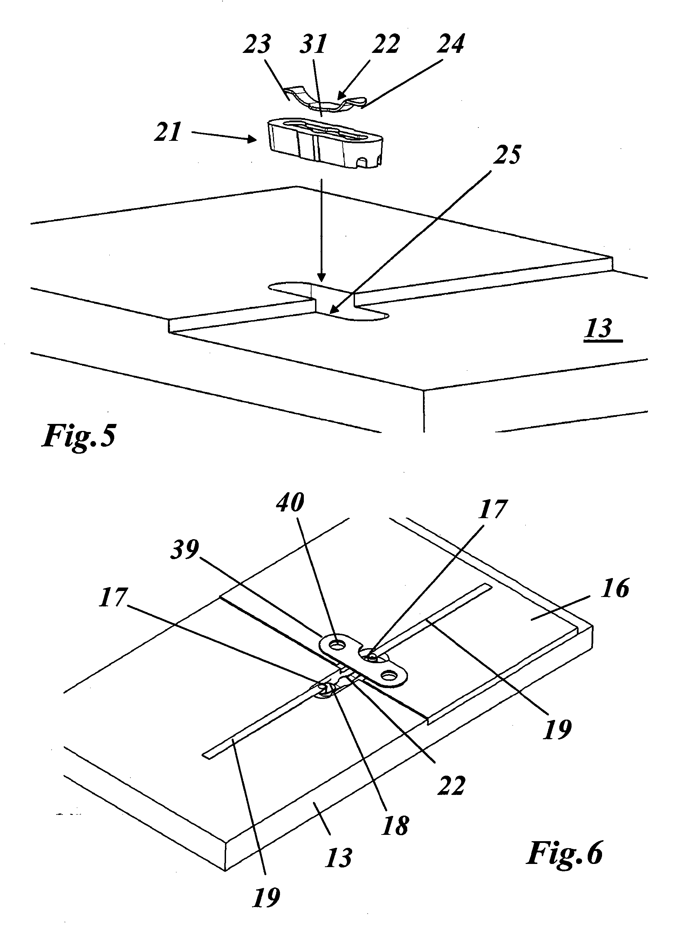

Das Kontaktierungselement 21 des Ausführungsbeispiels aus Fig. 3 ist unterhalb der beiden Printplatten 11, 12' angeordnet und in die Basisplatte 13' integriert. Dazu ist in der Basisplatte 13' eine unter dem Zwischenraum 14 hindurchgehende Ausnehmung 25 in Form eines Langlochs mit vertikalen Seitenwänden vorgesehen, dass beispielsweise in die Basisplatte 13' eingefräst oder giesstechnisch eingebracht sein kann (siehe auch Fig. 5). Die Ausnehmung 25 nimmt das Kontaktierungselement 21 auf und hält es klemmend fest. Das Kontaktierungselement 21 enthält auf der Oberseite eine elektrisch leitende, federnde Kontaktwippe 22 mit einem horizontalen Mittelstück 31 (Fig. 5), das auf entgegengesetzten Seiten in nach oben gebogene Kontaktzungen 23, 24 übergeht

Das Kontaktierungselement 21 ist so aufgebaut und auf die Ausnehmung 25 abgestimmt, dass es im eingesetzten Zustand mit den Kontaktzungen 23, 24 der Kontaktwippe 22 soweit aus der Ausnehmung 25 nach oben herausragt, dass die Kontaktzunge 23 kontaktierend gegen die Unterseite der Leiterplatte 11 drückt und die Kontaktzunge 24 in einem Bereich kontaktierend gegen die Unterseite der Leiterplatte 12' drückt, in dem die thermische Ableitplatte 16 entfernt oder weggelassen worden ist (Fig. 3). Die Kontaktwippe 22 ist in einer Vertiefung 27 auf der Oberseite eines elektrisch isolierenden Tragkörpers 26 gelagert. Der Tragkörper 26 ist aus einem elektrisch isolierenden Material, vorzugsweise einem Elastomer, und bildet ein Dielektrikum zwischen der durch die Kontaktwippe 22 hergestellten Signalleitung (Innenleiter) und der durch die Basisplatte 13' gebildeten Masseebene (Aussenleiter). Der Tragkörper 26 verjüngt sich nach unten zu leicht konisch, damit er (beispielsweise mittels eines Bestückungsroboters) leichter von oben in die Ausnehmung 25 eingesetzt werden kann. Der Tragkörper 26 wird aufgrund seiner elastischen Eigenschaften klemmend in der Ausnehmung 25 gehalten. Unterstützend wirken dabei zwei auf der Unterseite des Tragkörpers 26 in Längsrichtung verlaufende, nutartige Aussparungen 29 und 30. Die Kontaktwippe 22 ist ein Stanzbiegeteil und vorzugsweise aus Federbronze gefertigt und oberflächenveredelt, beispielsweise versilbert.

Die Vertiefung 27 auf der Oberseite des Tragkörpers 26 ist in der Randkontur an die Kontaktwippe 22 angepasst. Im Bereich des verbreiterten Mittelstücks 31 der Kontaktwippe 22 ist die Vertiefung 27 so ausgelegt, dass sich die in die Vertiefung 27 eingedrückte Kontaktwippe 22 mit den Seitenkanten des Mittelstücks 31 seitlich in den Tragkörper 26 eindrückt und so sicher im Tragkörper 26 gehalten wird. Unterstützt wird dieser Formschluss zwischen Mittelstück 31 und Tragkörper 26 durch seitlich angebrachte Verbreiterungen 28 des Tragkörpers 26, die beim Einsetzen in die Ausnehmung 25 zusätzlichen Druck nach innen erzeugen.

Zur Kontaktierung mit der Kontaktwippe 22 sind auf den Unterseiten der Printplatten 11 und 12' Kontaktflächen 18 ("Kontaktpads") angeordnet, die über Durchkontaktierungen 17 ("Vias") mit Leiterbahnen 19 auf der Oberseite der Printplatten 11, 12' elektrisch verbunden sind (siehe auch Fig. 6). Die Leiterbahnen 19, die Durchkontaktierungen 17, die Kontaktflächen 18 und die Kontaktwippe 22 bilden so den Innenleiter einer HF-tauglichen Signalleitung, über die beide Printplatten 11, 12' nach ihrem Einbau miteinander verbunden sind. Für den Fall, dass die Printplatten 11, 12' dem von unten durch die Kontaktwippe 22 ausgeübten Druck auf Dauer nicht standhalten und sich verformen würden, kann gemäss Fig. 6 auf der Oberseite der jeweiligen Printplatte 11 bzw. 12' eine sich quer über den Kontaktierungsbereich erstreckende, mechanisch stabile Halteplatte 39 vorgesehen werden, die über bis zur Basisplatte 13' durchgehende Befestigungslöcher 40 mit der Basisplatte 13' verschraubt wird. Dies kann insbesondere für die Printplatte 12' notwendig sein, weil durch das Fehlen der stabilisierenden Ableitplatte 16 im Bereich des Kontaktierungselements 21 die Stabilität der verbleibenden Schichtstruktur geringer ist

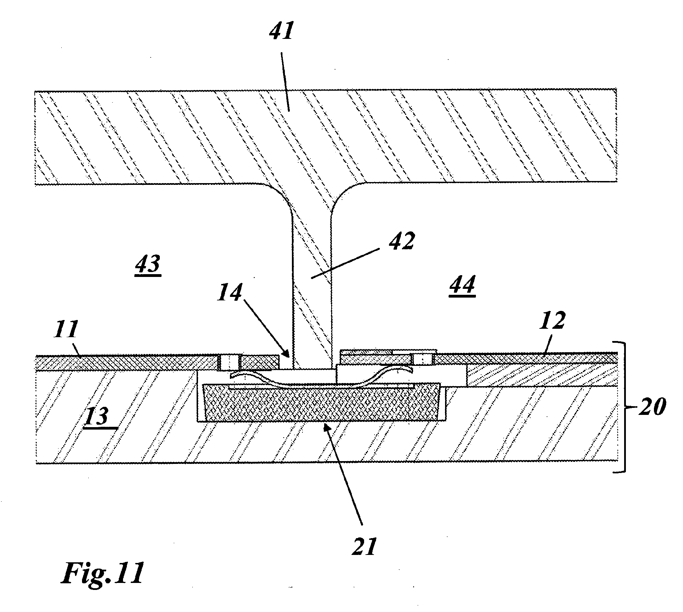

Durch das unterhalb der Printplatten 11, 12' in die Basisplatte 13' integrierte Kontaktierungselement 21 ergibt sich die vorteilhafte Möglichkeit, gemäss Fig. 11 die vertikale Trennwand 42 eines elektrisch leitenden Gehäuseteils 41 in dem Zwischenraum 14 direkt und vollflächig auf die Basisplatte 13' aufzusetzen und so den Raum über der Printplattenanordnung 20 in zwei abgeschirmte Räume 43 und 44 zu unterteilen, so dass die Schaltung auf der Printplatte 11 von der Schaltung auf der Printplatte 12' HF-mässig getrennt und nur über die Kontaktierungselemente 21 miteinander verbunden ist

Zur vollständigen elektromagnetischen Schirmung der Kontaktwippe auch ohne Gehäuseteil 41 kann die Basisplatte 13 am oberen Rand der Ausnehmung 25 eine weitere Vertiefung enthalten, die einen Schirmkörper 48 aufnimmt. Dieser Schirmkörper 48, vorzugsweise ein Schirmblech, ist so ausgelegt, dass es unter die jeweilige Vorderkante der Printplatten 11, 12 ragt und so eine schlüssige elektrisch leitende Verbindung mit der Metallisierung der Printplatten herstellt. Dazu ist die Struktur der Basisplatte 13 und Anordnung der Printplatten 11, 12, vorzugsweise so zu wählen, dass eine horizontale Ebene entsteht, um eine Stufe im Schirmkörper 48 zu vermeiden (der Schirmkörper 48 ist mit seiner Lage beispielhaft in Fig. 1 gestrichelt eingezeichnet).Die Printplattenanordnung gemäss Fig. 3-6 und 11 zeichnet sich durch folgende charakteristische Eigenschaften und Vorteile aus:
- Die Verbindung zwischen den Printplatten hat sehr gute HF-Eigenschaften.
- Sie ermöglicht durch den direkten Kontakt mit der Basisplatte die optimale Abschirmung der einzelnen Printplatten (Fig. 11).
- Von den eng bestückten Printplatten stehen seitlich keine Kontaktarme ab.
- Die Verbindung ist sehr lagetolerant: Die Kontaktkraft ist unabhängig von Verschiebungen der Printplatten in der Plattenebene (x-y-Ebene); Kontaktwippe und Tragkörper tragen aufgrund ihrer elastischen Eigenschaften zum Aufbau der Kontaktkräfte bei.
- Die Kontaktwippe und der Tragkörper können Höhentoleranzen der Printplatten in gewissem Umfang ausgleichen.
- Es können für die schaltungstechnische Auslegung der Printplatten die Standardregeln uneingeschränkt angewendet werden; insbesondere können die HF-Eigenschaften optimiert werden.
- Die Fähigkeit zur Übertragung von Gleichstrom über die Kontaktierungselemente 21 kann durch Einsatz mehrerer Vias pro Seite erhöht werden.
- Die mechanische Stabilität von PTFE-Printplatten kann durch die aufgeschraubten Halteplatten 39 erhöht werden.
- Es können unterschiedliche Längen der Verbindungen verwirklicht werden.
- Die Fähigkeit zur Übertragung von Gleichstrom über die Verbindungen kann nahezu beliebig gewählt werden.
- Die Verbindungen stellen eine nahezu ideal 50-Ohm-Umgebung ohne HF-Bandbegrenzung bis hinauf zur koaxialen Grenzfrequenz (z.B. 4 GHz) dar.
- Die Verbindungen sind unempfindlich gegen eine Veränderung der Lage der Printplatten während der Montage; es werden daher keine Führungsstifte benötigt; Toleranzen können einfach durch entsprechende Auslegung der Kontakt-Pads 18 aufgefangen werden.
- Die Anordnung ist mechanisch robust:
- Die Kontaktwippe ist ein einfaches Stanzbiegeteil.
- Die Montage des Kontaktierungselements 21 in der Basisplatte ist aufgrund der Selbstbeklemmung einfach.
- Die Kontaktierungselemente 21 können bis zur Montage mit einer Abdeckkappe auf einfache Weise geschützt werden.
- Die Handhabung und Montage der Printplatten ist besonders einfach: Auflegen und Festschrauben.
- Es ist keine spezielle Bestückungssequenz beim Aufbau der Printplatten nötig.
- Die Module können einfach und schnell repariert bzw. ausgetauscht werden.
- Der Aufwand für die Bereitstellungen der notwendigen Ausnehmungen in der Basisplatte und in der Ableitplatte ist gering.
- Durch die vorhandene Masseleitung über die Basisplatte 13 bzw. 13' braucht es zum Testen der Verbindung keinen Abschirmdeckel (Gehäuseteil 41 in Fig. 11).

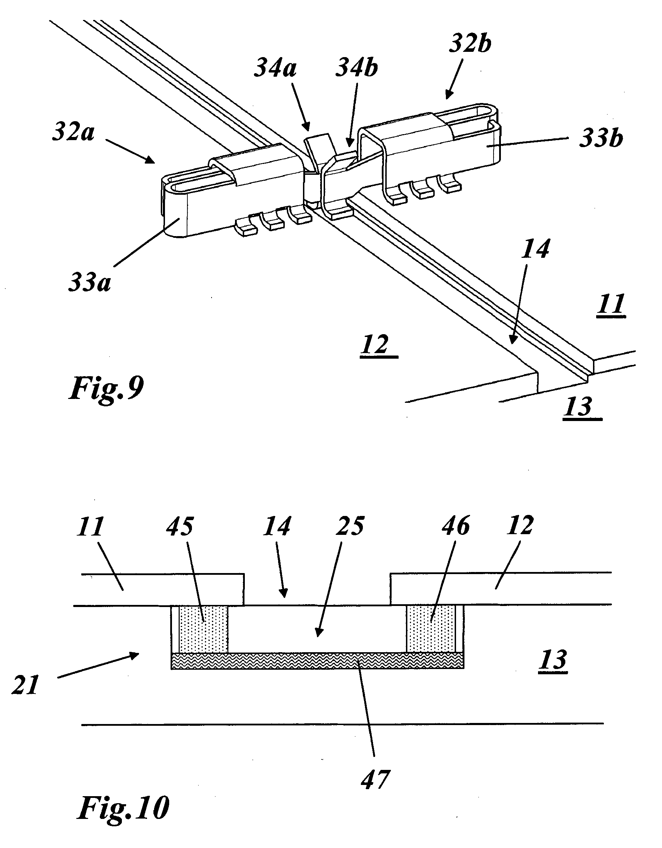

Anstelle des mit der Kontaktwippe 22 ausgerüsteten Kontaktierungselements 21 kann aber - wie dies in Fig. 10 beispielhaft angedeutet ist - auch ein Kontaktierungselement 21' in die Basisplatte 13 (oder 13') integriert werden, das Kontaktierungspfosten 45, 46 verwendet, wie sie beispielsweise in der eingangs genannten Druckschrift US-B1-6,231,352 beschrieben sind und auf dem Markt angeboten werden. Die beiden Kontaktierungspfosten 45, 46 werden mit der Lötseite auf eine weitere streifenförmige Printplatte 47 aufgelötet und dadurch miteinander elektrisch verbunden. Die Einheit aus Printplatte 47 und Kontaktierungspfosten 45, 46, wird so in die Ausnehmung 25 eingesetzt, dass die Kontaktierungspfosten 45, 46 mit ihren Druckkontakten von unten kontaktierend gegen die Printplatten 11 und 12 drücken, wenn diese auf die Basisplatte 13 aufgelegt werden.

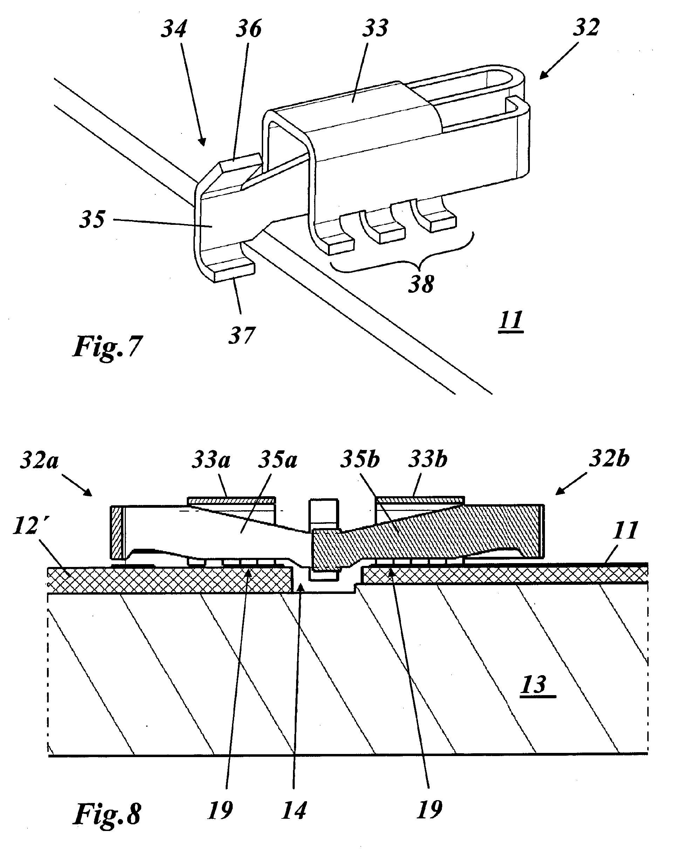

Eine andere Ausführungsform der erfindungsgemässen Printplattenanordnung ist in den Fig. 7 bis 9 wiedergegeben: Hier werden zwei gleichartige Kontaktierungselemente 32 bzw. 32a und 32b verwendet, die jeweils um 180° verdreht auf der Oberseite der Printplatten 11 und 12' auf eine entsprechende Leiterbahn aufgelötet sind und mit einem in der Plattenebene federnden Kontaktarm 35 bzw. 35a und 35b sich gegenseitig überlappend in den Zwischenraum 14 hineinragen (Fig. 8, 9). Die als Stanzbiegeteile vorzugsweise aus Federbronze hergestellten Kontaktierungselemente 32 weisen einen U-förmigen Körper 33 bzw. 33a, 33b auf, an dessen Schenkeln Lötfüsse 38 angeformt sind. Vom Körper 33 ausgehend erstreckt sich der Kontaktarm 35 zunächst nach hinten, macht eine 180°-Biegung und wird durch das Innere des Körpers 33 nach vorne herausgeführt, um eine ausreichende Länge des Arms zu ermöglichen. Am freien Ende des Kontaktarms 35 ist ein Kontaktabschnitt 34 ausgebildet, der eine annähernd quadratische Kontaktfläche umfasst, an die sich nach oben ein schräg (um 30°- 45°) nach aussen abgebogenes Einlaufelement 36 und nach unten ein rechtwinklig nach aussen abgebogenes Leitungselement 37 anschliesst.

Die Kontaktarme 35a, 35b der beiden Kontaktierungselemente 32a, 32b einer Verbindung überlappen und kontaktieren sich durch einen parallel zum Plattenrand ausgeübten Druck im Zwischenraum 14 mit der quadratischen Kontaktfläche, die aufgrund ihrer Ausdehnung eine Toleranz gegenüber Lagefehlern der Printplatten 11, 12' ermöglicht Die Einlaufelemente 36 erleichtern das gegenseitige Einlaufen der beiden Kontaktierungselemente 32a, 32b bei der Montage der Printplatten 11, 12'. Die Leitungselemente 37 verbessern die elektrischen Eigenschaften der Verbindung im Zusammenhang mit dem über die Basisplatte 13' geführten Aussenleiter. Demselben Zweck dient auch die Absenkung der Kontaktarme 35a, 35b im Bereich des Zwischenraums. Die Kontaktierungselemente 32a, 32b können wie andere Bauelemente mit der üblichen SMD-Löttechnik auf den Printplatten 11, 12' montiert und auf Gurten für die entsprechenden Automaten bereitgestellt werden. Mit ihnen können Signale bis zu einer Frequenz von 4GHz übertragen werden. Zur Erhöhung der mechanischen Festigkeit der Anordnung können Haltestifte vorgesehen werden, die in entsprechende Bohrungen auf der Printplatte gesteckt werden. Diese Haltebolzen können entweder direkt im Stanz-Biegekörper integriert sein, oder werden für verbesserte HF-Eigenschaften in einen umhüllenden Isolierkörper integriert. Dieser kann vorzugsweise in Kunstoff-Spritzguss-Insert-Technik ausgeführt sein.

Die charakteristischen Merkmale und Vorteile dieser Ausführungsform sind die folgenden:
- Die Kontaktierungselemente sind sehr klein und nehmen nicht viel Platz ein.
- Die Kontaktierungselemente sind symmetrisch und für beide Printplatten gleich.
- Die Kontaktierungselemente sind einfache Stanzbiegeteile.
- Sie können teilweise plattiert werden.
- Sie erfordern keine Änderungen an der Basisplatte bzw. der Ableitplatte.
- Durch die vorhandene Masseleitung über die Basisplatte 13 bzw. 13' braucht es zum Testen der Verbindung keinen Abschirmdeckel (analog zu Gehäuseteil 41 in Fig. 11).

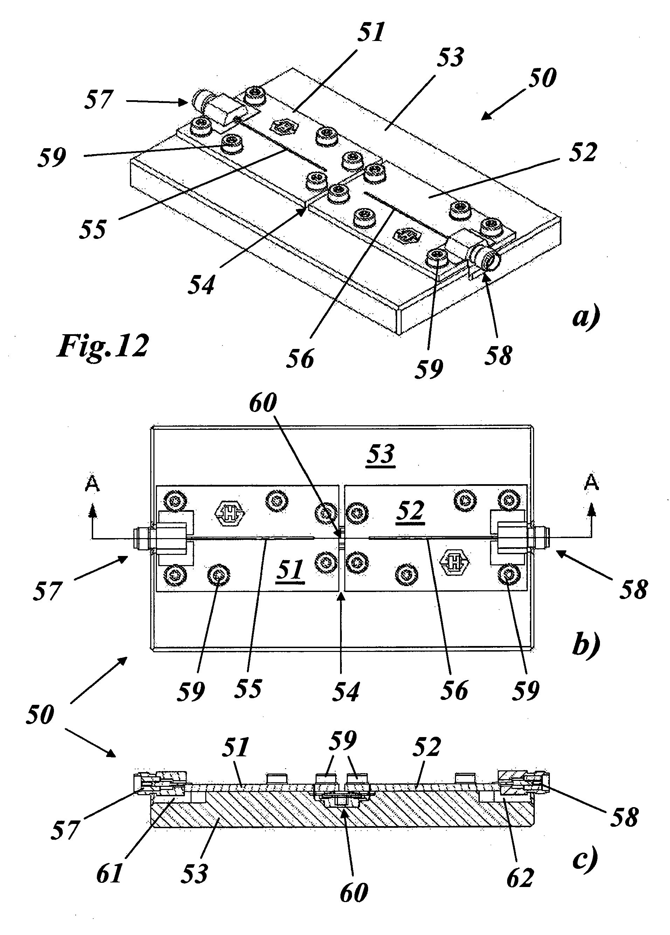

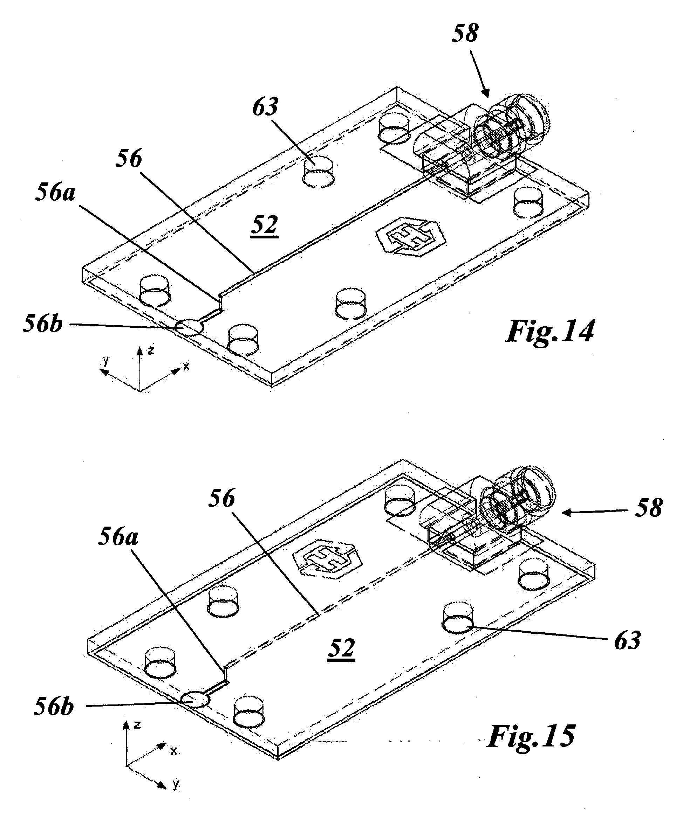

Ein weiteres Ausführungsbeispiel der Erfindung ist in den Fig. 12-15 wiedergegeben. Die Printplattenanordnung 50 dieses Ausführungsbeispiels geht aus von einer rechteckigen Basisplatte 53, auf deren Oberseite zwei Printplatten 51, 52 lösbar befestigt (aufgeschraubt) sind. Die beiden Printplatten 51, 52 sind gleichartig aufgebaut, aber auf der Basisplatte 53 zueinander spiegelbildlich montiert. Die beiden Printplatten 51, 52 sind an den Seiten, mit denen sie unter Ausbildung eines Zwischenraums 54 aneinander stoßen, durch ein in der Basisplatte 53 versenkt angeordnetes Kontaktierungselement 60 HF-gerecht miteinander verbunden. Jede der beiden Printplatten 51, 52 hat dem in Fig. 14 und Fig. 15 dargestellten Aufbau. An den außen liegenden Schmalseiten der Printplatten 51, 52 ist jeweils eine von außen zugängliche Anschlussbuchse 57, 58 angeordnet, an die eine entsprechende Leitung angeschlossen werden kann. Von der Anschlussbuchse 57, 58 führt auf der Oberseite der Printplatte 51, 52 eine zentrale, in Längsrichtung verlaufende Leiterbahn 55, 56 zu anderen Schmalseite der Printplatte, wo sie mittels einer Durchkontaktierung (56a in Fig. 14, 15) mit einer auf der Unterseite der Printplatte vorgesehenen Kontaktfläche (Pad) 56b leitend verbunden ist. Die Kontaktflächen 56b beider Printplatten 51, 52 werden zur Herstellung einer leitenden Verbindung zwischen den beiden Printplatten 51, 52 von dem darunter angeordneten Kontaktierungselement 60 kontaktiert.

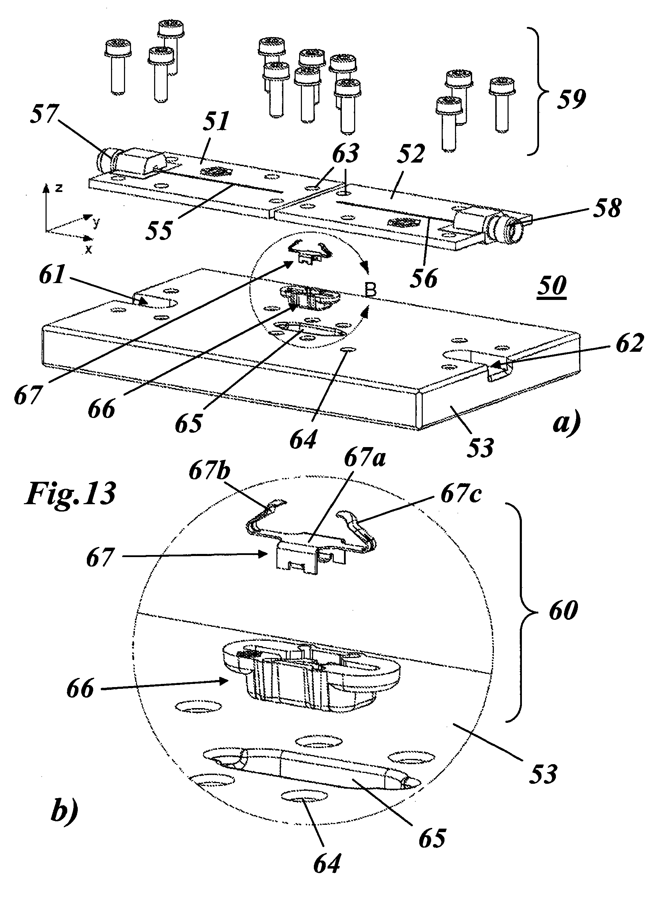

Das Kontaktierungselement 60 hat den in Fig. 13(b) gezeigten Aufbau. Für die Kontaktierung und leitende Verbindung der beiden Pads (56b) auf den Printplatten 51, 52 ist innerhalb des Kontaktierungselements 60 ein Kontaktkörper 67 vorgesehen, die als Stanzbiegeteil ausgebildet ist und einen Grundkörper 67a umfasst, von dem aus sich zu gegenüberliegenden Seiten spiegelbildlich zwei nach oben zurückgebogene Kontaktzungen 67b, 67c erstrecken. Der Kontaktkörper 67 ist elektrisch isoliert und feststehend (nicht wippend) in einem wannenförmig ausgebildeten Tragkörper 66 gelagert, der seinerseits in eine entsprechende Ausnehmung 65 in der Basisplatte 53 eingesetzt wird.

Die beiden Printplatten 51, 52 sind jeweils mit verteilt angeordneten Löchern 63 versehen, denen Gewindelöcher 64 in der Basisplatte 53 entsprechen. Die Printplatten 51, 52 werden mittels mehrerer Schrauben 59, die durch die Löcher 63 in den Printplatten 51, 52 gesteckt und in die Gewindelöcher 64 eingeschraubt werden, auf der Basisplatte 53 montiert. Um Platz für die nach unten aus den Printplatten 51, 52 heraus stehenden Anschlussbuchse 57, 58 zu schaffen, sind auf der Basisplatte 53 entsprechende Ausnehmungen 61, 62 vorgesehen.

Die Geometrie der Anordnung 50 ist so gewählt, dass die auf der Basisplatte 53 montiertem Printplatten 51, 52 mit ihren auf der Unterseite befindlichen Kontaktflächen 56b die Kontaktzungen 67b, c des Kontaktierungselements 60 federnd nach unten drücken und so einen sicheren und dauerhaften elektrischen Kontakt über den Kontaktkörper 67 zwischen den beiden Printplatten 51, 52 beziehungsweise den beiden Leiterbahnen 55, 56 herstellen.

### Bezugszeichenliste

- 10,20: Printplattenanordnung
- 11,12,12': Printplatte
- 13,13': Basisplatte
- 14: Zwischenraum
- 15: elektrische Verbindung (HF-tauglich)
- 16: Ableitplatte (thermisch)
- 17: Durchkontaktierung (Via)
- 18: Kontaktfläche (Pad)
- 19: Leiterbahn
- 21,21': Kontaktierungselement
- 22: Kontaktwippe
- 23,24: Kontaktzunge
- 25: Ausnehmung
- 26: Tragkörper (Dielektrikum)
- 27: Vertiefung
- 28: Verbreiterung
- 29,30: Aussparung (nutförmig)
- 31: Mittelstück
- 32,32a,32b: Kontaktierungselement
- 33,33a,33b: Körper (u-förmig)
- 34: Kontaktabschnitt
- 35,35a,35b: Kontaktarm
- 36: Einlaufelement
- 37: Leitungselement
- 38: Lötfuss
- 39: Halteplatte
- 40: Befestigungsloch
- 41: Gehäuseteil
- 42: Trennwand
- 43,44: abgeschirmter Raum
- 45,46: Kontaktpfosten
- 47: Printplatte
- 48: Schirmkörper (Schirmblech)
- 50: Printplattenanordnung
- 51,52: Printplatte
- 53: Basisplatte
- 54: Zwischenraum
- 55,56: Leiterbahn
- 56a: Durchkontaktierung
- 56b: Kontaktfläche
- 57,58: Anschlussbuchse
- 59: Schraube
- 60: Kontaktierungselement
- 61,62: Ausnehmung
- 63: Loch
- 64: Gewindeloch
- 65: Ausnehmung
- 66: Tragkörper
- 67: Kontaktkörper
- 67a: Grundkörper
- 67b, 67c: Kontaktzunge

## Patentansprüche

1. Printplattenanordnung (10, 20, 50) mit wenigstens zwei Printplatten (11; 12, 12'; 51, 52), die nebeneinander auf einer gemeinsamen, elektrisch leitenden Basisplatte (13, 13'; 53) aufliegen und sich mit zwei Kanten gegenüberliegen und mittels elektrischer Verbindungen (21; 21' 32a, 32b; 60) zur Übertragung höchster Frequenzen miteinander verbunden sind, **dadurch gekennzeichnet, dass** die elektrischen Verbindungen jeweils über wenigstens ein Kontaktierungselement (21; 21', 32a, 32b; 60) erfolgen, über das die Printplatten bei der Montage auf der Basisplatte (13, 13'; 53) lösbar miteinander in elektrischen Kontakt treten.

2. Printplattenanordnung nach Anspruch 1, **dadurch gekennzeichnet, dass** die elektrischen Verbindungen zwischen den beiden Printplatten (11; 12, 12'; 51, 52) durch Ausübung von gegenseitigem Druck zwischen den Printplatten (11; 12, 12') und/oder durch Druck zwischen den Printplatten (11; 12, 12'; 51, 52) und der Basisplatte (13, 13'; 53) hergestellt und aufrecht erhalten werden.

3. Printplattenanordnung nach Anspruch 2, **dadurch gekennzeichnet, dass** der Druck senkrecht zur Ebene der Printplatten (11; 12, 12'; 51, 52) wirkt

4. Printplattenanordnung nach Anspruch 2, **dadurch gekennzeichnet, dass** der Druck parallel zu den gegenüberliegenden Kanten der Printplatten (11; 12, 12') wirkt.

5. Printplattenanordnung nach Anspruch 3, **dadurch gekennzeichnet, dass** zum Herstellen der elektrischen Verbindungen wenigstens ein Kontaktierungselement (21; 21'; 60) vorgesehen ist, welches unterhalb der beiden Printplatten (11; 12, 12'; 51, 52) in einer Ausnehmung (25; 65) der Basisplatte (13, 13'; 53) angeordnet ist und beide Printplatten (11; 12, 12'; 51, 52) von unten lösbar kontaktiert und miteinander verbindet.

6. Printplattenanordnung nach Anspruch 5, **dadurch gekennzeichnet, dass** das Kontaktierungselement (21) eine Kontaktwippe (22) aufweist, die mit einem Mittelstück (31) in einem isolierenden Tragkörper (26) angeordnet und gehalten ist und an den Enden jeweils mit einer nach oben gebogenen Kontaktzunge (23, 24) aus dem Tragkörper (26) nach oben heraussteht, und dass der Tragkörper (26) mit der Kontaktwippe (22) derart in der zugehörigen Ausnehmung (25) der Basisplatte (13, 13') sitzt, dass die Kontaktzungen (23, 24) gleichzeitig von unten kontaktierend gegen die auf der Basisplatte (13, 13') aufliegenden Printplatten (11; 12, 12') drücken.

7. Printplattenanordnung nach Anspruch 6, **dadurch gekennzeichnet, dass** der Tragkörper (26) aus einem Elastomer besteht, dass der Tragkörper (26) in der Ausnehmung (25) klemmend gehalten wird, und dass die Kontaktwippe (22) in einer Vertiefung (27) auf der Oberseite des Tragkörpers (26) klemmend gehalten wird.

8. Printplattenanordnung nach Anspruch 7, **dadurch gekennzeichnet, dass** die Ausnehmung (25) die Form eines Langlochs aufweist, und die Randkontur des Tragkörpers (26) der Randkontur der Ausnehmung (25) angepasst ist.

9. Printplattenanordnung nach einem der Ansprüche 6 bis 8, **dadurch gekennzeichnet, dass** zur Kontaktierung durch die Kontaktzungen (23, 24) der Kontaktwippe (22) auf der Unterseite der beiden Printplatten (11; 12, 12') jeweils eine Kontaktfläche (18) vorgesehen ist, die über eine Durchkontaktierung (17) mit einer Leiterbahn (19) auf der Oberseite der Printplatte (11; 12, 12') verbunden ist

10. Printplattenanordnung nach einem der Ansprüche 6 bis 9, **dadurch gekennzeichnet, dass** Mittel (39, 40) vorgesehen sind, um wenigstens eine der Printplatten (11; 12, 12') im Bereich der Kontaktzungen (23, 24) gegen den Druck der Kontaktwippe (22) auf der Basisplatte (13, 13') niederzuhalten.

11. Printplattenanordnung nach einem der Ansprüche 6 bis 10, **dadurch gekennzeichnet, dass** zwischen den beiden Printplatten (11; 12, 12') ein Zwischenraum (14) frei bleibt, dass die Kontaktwippe (22) im Bereich des Zwischenraums (14) unterhalb der Ebene der Oberseite der Basisplatte (13, 13') verläuft, und dass ein elektrisch leitendes Gehäuseteil (41) mit einer vertikalen Trennwand (42) im Bereich des Zwischenraums (14) auf die Basisplatte (13, 13') derart kontaktierend aufsetzt, dass der Raum oberhalb der beiden Printplatten (11; 12, 12') in zwei den Printplatten (11; 12, 12') zugeordnete, separate, abgeschirmte Räume (43, 44) unterteilt wird.

12. Printplattenanordnung nach Anspruch 5, **dadurch gekennzeichnet, dass** das Kontaktierungselement (21') eine weitere Printplatte (47) aufweist, auf der im Bereich der Printplatten (11; 12, 12') Kontaktpfosten (45, 46) angeordnet und über die weitere Printplatte (47) untereinander leitend verbunden sind, und dass die weitere Printplatte (47) mit den Kontaktpfosten (45, 46) derart in der zugehörigen Ausnehmung (25) der Basisplatte (13, 13') sitzt, dass die Kontaktpfosten (45, 46) gleichzeitig von unten kontaktierend gegen die auf der Basisplatte (13, 13') aufliegenden Printplatten (11; 12, 12') drücken.

13. Printplattenanordnung nach Anspruch 4, **dadurch gekennzeichnet, dass** zwischen den beiden Printplatten (11; 12, 12') ein Zwischenraum (14) frei bleibt, dass zum Herstellen der elektrischen Verbindungen jeweils zwei Kontaktierungselemente (32; 32a, 32b) vorgesehen sind, welche auf der Oberseite der beiden Printplatten (11; 12, 12') derart angeordnet sind, dass sie von beiden Seiten in den Zwischenraum (14) hineinragen und sich lösbar kontaktieren und die beiden Printplatten (11; 12, 12') miteinander verbinden.

14. Printplattenanordnung nach Anspruch 13, **dadurch gekennzeichnet, dass** die beiden Kontaktierungselemente (32; 32a, 32b) gleich sind, dass jedes Kontaktierungselement (32; 32a, 32b) als anlötbares Stanzbiegeteil ausgebildet ist und einen U-förmigen Körper (33; 33a, 33b) aufweist, aus dem seitlich ein federnder Kontaktarm (35; 35a, 35b) herausragt und an seinem freien Ende mit einem Kontaktabschnitt (34) versehen ist, und dass die beiden Kontaktierungselemente (32; 32a, 32b) mit ihren Kontaktabschnitte (34) im Zwischenraum (14) überlappen und federnd gegeneinander drücken.

15. Printplattenanordnung nach Anspruch 14, **dadurch gekennzeichnet, dass** die Kontaktierungselemente (32; 32a, 32b) jeweils am Körper (33; 33a, 33b) angeformte Lötfüsse (38) aufweisen, dass in den Kontaktabschnitten (34) oben jeweils ein schräg nach aussen abgebogenes Einlaufelement (36) angeformt ist, dass in den Kontaktabschnitten (34) unten jeweils ein rechtwinklig nach aussen abgebogenes Leitungselement (37) angeformt ist, und dass die Kontaktabschnitte (34) von oben in den Zwischenraum (14) eintauchen.

16. Printplattenanordnung nach Anspruch 5, **dadurch gekennzeichnet, dass** das Kontaktierungselement (60) einen Kontaktkörper (67) aufweist, der mit einem Grundkörper (67a) in einem isolierenden Tragkörper (66) angeordnet und gehalten ist und an den Enden jeweils mit einer nach oben zurückgebogenen Kontaktzunge (67b, 67c) aus dem Tragkörper (66) nach oben heraussteht, und dass der Tragkörper (66) mit dem Kontaktkörper (67) derart in der zugehörigen Ausnehmung (65) der Basisplatte (53) sitzt, dass die Kontaktzungen (67b, 67c) gleichzeitig von unten kontaktierend gegen die auf der Basisplatte (53) aufliegenden Printplatten (51, 52) drücken.

17. Printplattenanordnung nach Anspruch 16, **dadurch gekennzeichnet, dass** der Tragkörper (66) aus einem Elastomer besteht, und dass der Tragkörper (66) in der Ausnehmung (65) klemmend gehalten wird.

18. Printplattenanordnung nach Anspruch 17, **dadurch gekennzeichnet, dass** die Ausnehmung (65) die Form eines Langlochs aufweist, und die Randkontur des Tragkörpers (66) der Randkontur der Ausnehmung (65) angepasst ist

19. Printplattenanordnung nach einem der Ansprüche 16 bis 18, **dadurch gekennzeichnet, dass** zur Kontaktierung durch die Kontaktzungen (67b, 67c) des Kontaktkörpers (67) auf der Unterseite der beiden Printplatten (51, 52) jeweils eine Kontaktfläche (56b) vorgesehen ist, die über eine Durchkontaktierung (56a) mit einer Leiterbahn (55, 56) auf der Oberseite der Printplatte (51, 52) verbunden ist

## Claims

1. A printed board arrangement (10, 20, 50) having at least two printed boards (11; 12, 12'; 51, 52) which rest next to one another on a common, electrically conducting base plate (13, 13'; 53), and which, with two edges, are positioned opposite one another and are connected to one another by means of electrical connections (21; 21', 32a, 32b; 60) for transmitting highest frequencies, **characterized in that** the electrical connections are in each case established by means of at least one contacting element (21; 21', 32a, 32b; 60) and that, when they are mounted on the base plate (13, 13'; 53), the printed boards come into electrical contact with one another in a releasable manner.

2. The printed board arrangement as claimed in claim 1, **characterized in that** the electrical connections between the two printed boards (11; 12, 12'; 51, 52) are produced and maintained by the exertion of reciprocal force between the printed boards (11; 12, 12') and/or by force between the printed boards (11; 12, 12'; 51, 52) and the base plate (13, 13'; 53).

3. The printed board arrangement as claimed in claim 2, **characterized in that** the force acts perpendicular to the plane of the printed boards (11; 12, 12'; 51, 52).

4. The printed board arrangement as claimed in claim 2, **characterized in that** the force acts parallel to the opposing edges of the printed boards (11; 12, 12').

5. The printed board arrangement as claimed in claim 3, **characterized in that**, in order to produce the electrical connections, at least one contacting element (21; 21'; 60), which is arranged beneath the two printed boards (11; 12, 12'; 51, 52) in a recess (25; 65) of the base plate (13, 13'; 53), is provided and makes contact with and connects the two printed boards (11; 12, 12'; 51, 52) to one another in a releasable manner from below.

6. The printed board arrangement as claimed in claim 5, **characterized in that** the contacting element (21) has a contact rocker (22) which is arranged and retained with a center piece (31) in an insulating supporting body (26) and, at the ends, projects upwards out of the supporting body (26), in each case with an upwardly bent contact tongue (23, 24), and that the support body (26) sits with the contact rocker (22) in the associated recess (25) of the base plate (13, 13') in such a way that the contact tongues (23, 24) simultaneously press from below in a contacting manner against the printed boards (11; 12, 12') which rest on the base plate (13, 13').

7. The printed board arrangement as claimed in claim 6, **characterized in that** the supporting body (26) is made of an elastomer, that the supporting body (26) is held in a clamping manner in the recess (25), and that the contact rocker (22) is held in a clamping manner in a depression (27) on the top of the supporting body (26).

8. The printed board arrangement as claimed in claim 7, **characterized in that** the recess (25) has the form of a slot, and the edge contour of the supporting body (26) is matched to the edge contour of the recess (25).

9. The printed board arrangement as claimed in one of claims 6 to 8, **characterized in that** a contact surface (18), which is connected by means of a plated-through hole (17) to a conductor track (19) on the top of the printed board (11; 12, 1 2'), is in each case provided on the underside of the two printed boards (11; 12, 12') for the contact tongues (23, 24) of the contact rocker (22) to make contact.

10. The printed board arrangement as claimed in one of claims 6 to 9, **characterized in that** means (39, 40) are provided to hold down at least one of the printed boards (11; 12, 12') on the base plate (13, 13') against the force of the contact rocker (22) in the region of the contact tongues (23, 24).

11. The printed board arrangement as claimed in one of claims 6 to 10, **characterized in that** an intermediate space (14) remains free between the two printed boards (11; 12, 12'), that the contact rocker (22) runs below the plane of the top of the base plate (13, 13') in the region of the intermediate space (14), and that an electrically conducting housing part (41) with a vertical dividing wall (42) rests in a contacting manner on the base plate (13, 13') in the region of the intermediate space (14) in such a way that the space above the two printed boards (11; 12, 12') is divided into two separate, screened spaces (43, 44) associated with the printed boards (11; 12, 12').

12. The printed board arrangement as claimed in claim 5, **characterized in that** the contacting element (21') has a further printed board (47) on which contact posts (45, 46) are arranged in the region of the printed boards (11; 12, 12') and are conductively connected to one another by means of the further printed board (47), and that the further printed board (47) with the contact posts (45, 46) sits in the associated recess (25) of the base plate (13, 13') in such a way that the contact posts (45, 46) simultaneously press from below in a contacting manner against the printed boards (11;12,12') which rest on the base plate (13, 13').

13. The printed board arrangement as claimed in claim 4, **characterized in that** an intermediate space (14) remains free between the two printed boards (11; 12, 12'), that in each case two contacting elements (32; 32a, 32b), which are arranged on the top of the two printed boards (11; 12, 12') in such a way that they project into the intermediate space (14) from both sides and make contact with one another in a releasable manner and connect the two printed boards (11; 12, 12') to one another, are provided in order to make the electrical connections.

14. The printed board arrangement as claimed in claim 13, **characterized in that** the two contacting elements (32; 32a, 32b) are the same, that each contacting element (32; 32a, 32b) is designed in the form of a solderable pressed-and-bent part and has a U-shaped body (33; 33a, 33b) from which a spring contact arm (35; 35a, 35b) projects and which is provided with a contact section (34) at its free end, and that the contact sections (34) of the two contacting elements (32; 32a, 32b) overlap and press against one another under spring pressure in the intermediate space (14).

15. The printed board arrangement as claimed in claim 14, **characterized in that** the contacting elements (32; 32a, 32b) in each case have solder feet (38) which are formed on the body (33; 33a, 33b), that an infeed element (36), which is bent outwards at an angle, is in each case formed in the contact sections (34) at the top, that a conductor element (37), which is bent outwards at right angles, is in each case formed in the contact sections (34) at the bottom, and that the contact sections (34) project into the intermediate space (14) from above.

16. The printed board arrangement as claimed in claim 5, **characterized in that** the contacting element (60) has a contact body (67) which is arranged and retained with a base body (67a) in an insulating supporting body (66) and, at the ends, projects upwards out of the supporting body (66), in each case with a bent-back contact tongue (67b, 67c), and that the supporting body (66) sits with the contact body (67) in the associated recess (65) of the base plate (53) in such a way that the contact tongues (67b, 67c) simultaneously press from below in a contacting manner against the printed boards (51, 52) which rest on the base plate (53).

17. The printed board arrangement as claimed in claim 16, **characterized in that** the supporting body (66) is made of an elastomer and that the supporting body (66) is held in a clamping manner in the recess (65).

18. The printed board arrangement as claimed in claim 17, **characterized in that** the recess (65) has the form of a slot, and the edge contour of the supporting body (66) is matched to the edge contour of the recess (65).

19. The printed board arrangement as claimed in one of claims 16 to 18, **characterized in that** a contact surface (56b), which is connected by means of a plated-through hole (56a) to a conductor track (55, 56) on the top of the printed board (51, 52), is in each case provided on the underside of the two printed boards (51, 52) for the contact tongues (67b, 67c) of the contact body (67) to make contact.

## Revendications

1. Ensemble de cartes de circuit imprimé (10, 20, 50) comportant au moins deux cartes de circuit imprimé (11; 12, 12' ; 51, 52) qui sont reposent l'une à côté de l'autre sur une plaque de base commune conductrice de l'électricité (13, 13' ; 53), se font face par deux chants et sont reliées l'une à l'autre pour la transmission de très hautes fréquences par des liaisons électriques (21 ; 21', 32a, 32b ; 60), **caractérisé par le fait que** les liaisons électriques s'établissent chacune par l'intermédiaire d'au moins un élément de mise en contact (21 ; 21', 32a, 32b ; 60) par l'intermédiaire duquel les cartes de circuit imprimé entrent en contact électrique entre elles de façon séparable lors du montage sur la plaque de base (13, 13' ; 53).

2. Ensemble de cartes de circuit imprimé selon la revendication 1, **caractérisé par le fait que** les liaisons électriques entre les deux cartes de circuit imprimé (11 ; 12, 12' ; 51, 52) sont établies et maintenues par l'application d'une pression mutuelle entre les cartes de circuit imprimé (11 ; 12, 12') et/ou par une pression entre les cartes de circuit imprimé (11 ; 12, 12' ; 51, 52) et la plaque de base (13, 13' ; 53).

3. Ensemble de cartes de circuit imprimé selon la revendication 2, **caractérisé par le fait que** la pression agit perpendiculairement au plan des cartes de circuit imprimé (11 ; 1 2, 12' ; 51, 52).

4. Ensemble de cartes de circuit imprimé selon la revendication 2, **caractérisé par le fait que** la pression agit parallèlement aux chants se faisant face des cartes de circuit imprimé (11; 12, 12').

5. Ensemble de cartes de circuit imprimé selon la revendication 3, **caractérisé par le fait que**, pour créer les liaisons électriques, il comprend au moins un élément de mise en contact (21 ; 21' ; 60), qui est disposé au-dessous des deux cartes de circuit imprimé (11 ; 12, 12' ; 51, 52), dans un évidement (25 ; 65) de la plaque de base (13, 13' ; 53), et les deux cartes de circuit imprimé (11 ; 12, 12' ; 51, 52) sont mises en contact et reliées l'une à l'autre par-dessous de façon séparable.

6. Ensemble de cartes de circuit imprimé selon la revendication 5, **caractérisé par le fait que** l'élément de mise en contact (21) présente une bascule de contact (22) qui est disposée et retenue par une partie centrale (31) dans un corps porteur isolant (26) et qui, à chacune de ses extrémités, émerge du corps porteur (26) de bas en haut par une languette de contact (23, 24) recourbée vers le haut (23, 24), et **par le fait que** le corps porteur (26), muni de la bascule de contact (22), est logé dans l'évidement correspondant (25) de la plaque de base (13, 13') de telle sorte que les languettes de contact (23, 24) sont pressées simultanément par dessous et avec mise en contact contre les cartes de circuit imprimé (11 ; 12, 12') reposant sur la plaque de base 13, 13').

7. Ensemble de cartes de circuit imprimé selon la revendication 6, **caractérisé par le fait que** le corps porteur (26) est composé d'un élastomère, **par le fait que** le corps porteur (26) est retenu dans l'évidement (25) par serrage et **par le fait que** la bascule de contact (22) est tenue par serrage dans une cavité (27) formée sur la face supérieure du corps porteur (26).

8. Ensemble de cartes de circuit imprimé selon la revendication 7, **caractérisé par le fait que** l'évidement (25) présente la forme d'un trou allongé et le profil du bord du corps porteur (26) est adapté au profil du bord de l'évidement (25).

9. Ensemble de cartes de circuit imprimé selon l'une des revendications 6 à 8, **caractérisé par le fait que**, pour la mise en contact par les languettes de contact (23, 24) de la bascule de contact (22), sur la face inférieure de chacune des deux cartes de circuit imprimé (11 ; 12, 12') est prévue une surface de contact (18) qui est reliée par l'intermédiaire d'une métallisation de trou (17) à une piste conductrice (19) sur la face supérieure de la carte de circuit imprimé (11 ; 12, 12').

10. Ensemble de cartes de circuit imprimé selon l'une des revendications 6 à 9, **caractérisé par le fait que** des moyens (39, 40) sont prévus pour maintenir au moins l'une des cartes de circuit imprimé (11; 12, 12') sur la plaque de base (13, 13') dans la région des languettes de contact (23, 24) à l'encontre de la pression de la bascule de contact (22).

11. Ensemble de cartes de circuit imprimé selon l'une des revendications 6 à 10, **caractérisé par le fait qu'**entre les deux cartes de circuit imprimé (11 ; 12, 12'), il reste libre un espace intermédiaire (14), **par le fait que** la bascule de contact (22) s'étend dans la région de l'espace intermédiaire (14) au-dessous du plan de la face supérieure de la plaque de base (13, 13') et **par le fait qu'**une partie de boîtier (41) conductrice de l'électricité s'appuie sur la plaque de base (13, 13') par une paroi de séparation verticale (42) dans la région de l'espace intermédiaire (14) avec mise en contact de telle sorte que l'espace surmontant les deux cartes de circuit imprimé (11 ; 12, 12') est divisé en deux espaces séparés et blindés (43, 44) qui correspondent aux cartes de circuit imprimé (11 ; 12, 12').

12. Ensemble de cartes de circuit imprimé selon la revendication 5, **caractérisé par le fait que** l'élément de mise en contact (21') présente une autre carte de circuit imprimé (47) sur laquelle, dans la région des cartes de circuit imprimé (11; 12, 12'), des colonnettes de contact (45, 46) sont disposées et sont reliées de façon conductrice entre elles par l'autre carte de circuit imprimé (47) et **par le fait que** l'autre carte de circuit imprimé (47) prend appui par les colonnettes de contact (45, 46) dans l'évidement correspondant (25) de la plaque de base (13, 13') de telle sorte que les colonnettes de contact (45,46) exercent en même temps une pression par dessous, avec mise en contact, contre les cartes de circuit imprimé (11 ; 12, 12') qui reposent sur la plaque de base (13, 13').

13. Ensemble de cartes de circuit imprimé selon la revendication 4, **caractérisé par le fait qu'**entre les deux cartes de circuit imprimé (11 ; 12, 12'), il reste libre un espace intermédiaire (14), **par le fait que**, pour l'établissement des liaisons électriques, à chaque fois deux éléments de mise en contact (30 ; 32a, 32b) sont prévus, qui sont sur la face supérieure des deux cartes de circuit imprimé (11 ; 12, 12') de telle sorte qu'ils débordent des deux côtés dans l'espace intermédiaire (14) et entrent en contact de façon séparable et relient les deux cartes de circuit imprimé (11 ; 12, 12') l'une à l'autre.

14. Ensemble de cartes de circuit imprimé selon la revendication 13, **caractérisé par le fait que** les deux éléments de mise en contact (32 ; 32a, 32b) sont identiques, **par le fait que** chaque élément de mise en contact (32 ; 32a, 32b) est constitué par une pièce découpée et pliée pouvant être brasée, et présente un corps en forme de U (33 ; 33a, 33b) sur lequel un bras de contact élastique (35 ; 35a, 35b) fait saillie latéralement et est muni d'un segment de contact (34) à son extrémité libre, et **par le fait que** les deux éléments de mise en contact (32 ; 32a, 32b) se chevauchent par leurs segments de contact (34) dans l'espace intermédiaire (14) et sont pressés élastiquement l'un contre l'autre.

15. Ensemble de cartes de circuit imprimé selon la revendication 14, **caractérisé par le fait que** les éléments de mise en contact (32 ; 32a, 32b) présentent chacun des pieds à braser (38) formés sur le corps (33 ; 33a, 33b), **par le fait que**, dans chacun des segments de contact (34) est formé, dans la partie haute, un élément d'entrée (36) coudé obliquement vers l'extérieur, **par le fait que**, dans chacun des segments de contact (34) est formé, dans la partie basse, un élément conducteur (37) coudé à angle droit vers l'extérieur, et **par le fait que** les segments de contact (34) s'engagent de haut en bas dans l'espace intermédiaire (14).

16. Ensemble de cartes de circuit imprimé selon la revendication 5, **caractérisé par le fait que** l'élément de mise en contact (60) présente un corps de contact (67) qui est disposé et retenu par un corps de base (67a) dans un corps porteur isolant (66) et, à chacune des extrémités, fait saillie vers le haut en dehors du corps porteur (66) par une languette de contact (67b, 67c) recourbée en arrière et vers le haut, et **par le fait que** le corps porteur (66) prend appui par le corps de contact (67) dans l'évidement correspondant (65) de la plaque de base (53) de telle sorte que les languettes de contact (67b, 67c) exercent en même temps une pression par dessous avec mise en contact contre les cartes de circuit imprimé (51, 52) reposant sur la plaque de base (53).

17. Ensemble de cartes de circuit imprimé selon la revendication 16, **caractérisé par le fait que** le corps porteur (66) est fait d'un élastomère et **par le fait que** le corps porteur (66) est tenu par serrage dans l'évidement (65).

18. Ensemble de cartes de circuit imprimé selon la revendication 17, **caractérisé par le fait que** l'évidement (65) présente la forme d'un trou allongé et le profil du bord du corps porteur (66) est adapté au profil du bord de l'évidement (65).

19. Ensemble de cartes de circuit imprimé selon l'une des revendications 16 à 18, **caractérisé par le fait qu'**il présente, pour la mise en contact par les languettes de contact (67b, 67c) du corps de contact (67) appuyées contre la face inférieure de chacune des deux cartes de circuit imprimé (51, 52), une surface de contact (56b) qui est reliée par une métallisation de trou (56a) à une piste conductrice (55, 56) sur la face supérieure de la carte de circuit imprimé (51, 52).
